# EUROPEAN PATENT SPECIFICATION

(11) **EP 2 575 063 B1**
(45) Date of publication and mention of the grant of the patent: **24.07.2013**
(21) Application number: 12007432.3
(22) Date of filing: 30.10.2012
(51) Int. Cl.: G06F 17/50

(54) **Process for automatically wiring and routing for networks of plants**
Verfahren zur automatischen Verdrahtung und Verlegung für Netzwerke von Anlagen
Procédé de routage et de câblage automatique pour réseaux de centrales

(30) Priority: 13.12.2011 IT TO20111146
(43) Date of publication of application: 03.04.2013
(73) Proprietor: Fusco, Carlo, 10133 Torino (IT)
(72) Inventor: Fusco, Carlo, 10133 Torino (IT)
(74) Representative: Garavelli, Paolo

(56) References cited:
- KISHORE KSHIRSAGAR ET AL: "Design of 2-level hierarchical ring networks", ULTRA MODERN TELECOMMUNICATIONS AND CONTROL SYSTEMS AND WORKSHOPS (ICUMT), 2011 3RD INTERNATIONAL CONGRESS ON, IEEE, 5 October 2011 (2011-10-05), pages 1-7, XP032021338, ISBN: 978-1-4577-0682-0
- HAIXUN WANG ET AL: "Dual Labeling: Answering Graph Reachability Queries in Constant Time", DATA ENGINEERING, 2006. ICDE '06. PROCEEDINGS OF THE 22ND INTERNATIONA L CONFERENCE ON ATLANTA, GA, USA 03-07 APRIL 2006, PISCATAWAY, NJ, USA,IEEE, 3 April 2006 (2006-04-03), pages 75-75, XP010911735, DOI: 10.1109/ICDE.2006.53 ISBN: 978-0-7695-2570-9
- YUUSAKU NAKAMURA ET AL: "Efficient reachability test on directed graphs and its application to large XML data", DATABASES FOR NEXT GENERATION RESEARCHERS, 2007. SWOD 2007. IEEE INTER NATIONAL WORKSHOP ON, IEEE, PI, 1 April 2007 (2007-04-01), pages 25-30, XP031080590, ISBN: 978-1-4244-0903-7
- Christopher Skiscim: "Optimization by simulated annealing: A preliminary computational study for the TSP", , 12 December 1983 (1983-12-12), pages 523-535, XP055047753, Retrieved from the Internet: URL:http://delivery.acm.org/10.1145/810000 /801546/p523-skiscim.pdf?ip=145.64.134.245 &acc=ACTIVE SERVICE&CFID=156539029&CFTOKEN=40218120&__ acm__=1355406113_3be694b849cb822809acea443 a6c4e08 [retrieved on 2012-12-13]

## Description

The present invention refers to a process for automatically wiring and routing for networks of plants.

In order to better define the invention, the following terminology will be adopted herein below:
**node:** connection node of two branches;
**branch:** connection between two nodes;
**device:** device node to be connected with a cable or network;
**central unit:** device dfrom which all connections start;
**section:** block symbolising the designer's wish to trace circuits that pass where its insertion point on a branch is placed. Physically, it can show, for example, a cut-out of an electric raceway (observation windows);
**connection branch (or connection):** branch or set of branches connecting two devices;
**connection path:** set of connection branches starting from the central unit;
**plant:** set of devices distinguished by a certain function;
**circuit:** subset of a plant;
**start connection (or star):** set of connections connecting all devices of a circuit to the central unit, with a minimum connection path dedicated by the central unit for each device realising, in this way, a shape of a star, where the star centre is composed of the central unit;
**bus connection (or bus):** a connection path connecting all devices of a circuit to the central unit, so that every connection branch connects a device to the following one starting from the central unit.
**loop connection (loop):** a connection path connecting all devices of a circuit to the central unit, so that every connection branch connects a device to the following one starting from the central unit, in order to be closed onto the central unit as a loop.

Distribution and/or connection networks used for equipment and in plants, are known in the art. When manually designing such networks, not always an optimum solution is obtained for the application in which they are provided, given the manual nature of such designs.

Object of the present invention is solving the above prior art problems by providing a process that allows optimally automating the designing process of such distribution and/or connection networks, finding the minimum path for reaching all equipment connected to such network.

The above and other objects and advantages of the invention, as will appear from the following description, are obtained with a process as described in claim 1 and with a computer product that allows performing such process. Preferred embodiments and non-trivial variations of the present invention are the subject matter of the dependent claims.

It is intended that the claims are an integral part of the present specification.

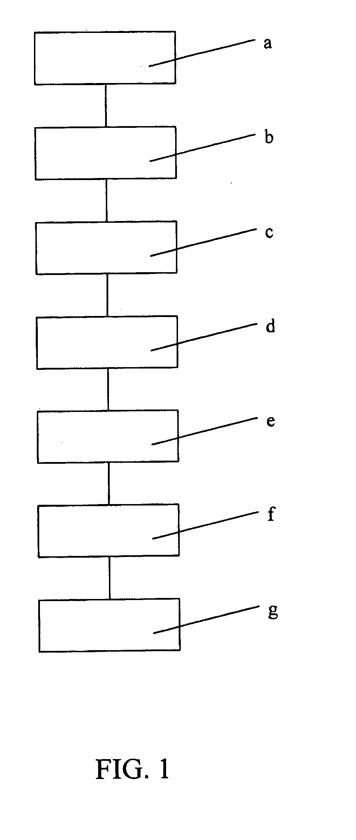

The present invention will be better described by some preferred embodiments thereof, provided as a non-limiting example, with reference to the enclosed drawings, in which the only Figure 1 is a schematic block view of the main phases of the inventive process.

Document D1 (KISHORE ET AL: "Design of 2-level hierarchical ring networks", ULTRA MODERN TELECOMMUNICATIONS AND CONTROL SYSTEMS AND WORKSHOPS (ICUMT), 2011 3RD INTERNATIONAL CONGRESS ON, IEEE, October 2011) describes a method for automatically wiring and routing networks of plants, in which a graph of the network is build and a spanning tree is constructed as a first step in solving a travelling salesman problem to locate shortest connection path connecting all graph nodes.

With reference to Figure 1, a preferred embodiment of the process of the present invention is shown and described. It will be immediately obvious that numerous variations and modifications (for example related to shape, sizes, arrangements and parts with equivalent functionality) can be made to what is described, without departing from the scope of the invention as appears from the enclosed claims.

The inventive process finds a wide application in making big-sized plants in several sectors. A non-limiting list, as an example, is included below:
- Infrastructures
   ○ transport system, railways, stations, bus lines, tramway lines
- Big houses and buildings in general
   ○ Structured wiring of plants, pipe and distribution networks in general.
- Petrol-chemical field
   ○ routing of pipe and distribution networks in general
- Power
   ○ routing of pipe and distribution networks in general
- Industrial automation
   ○ structured wiring
- Everywhere there is the need of creating a distribution and/or connection network constrained to several possible paths, and connecting various kinds of terminal equipment

The inventive process allows solving the above-mentioned problems by acquiring, from a graphic electronic data base (CAD) or other source, the possible constraint paths and the terminals to be reached and by using, afterwards, modified versions of some evolved algorithms of the theory of graphs, in order to find minimum paths for connecting all terminals.

Moreover, the process performs some computations for dimensioning the connection network.

The program operates on a CAD data base representing the plant design, in which:
- the various routes that can be used (raceways, cable ways in case of an electric plant) are represented by poly-lines (sets of segments mutually connected and joined);
- the devices are blocks with at least one attribute of the "name" type (optionally also one as detachment length) and an insertion point;

- the nodes, symbolising the connection of many raceways, are blocks with an insertion point (which must be overlapped to both connected raceways);
- other nodes can represent the passage between many planes (skylight passage).

The process is performed through the following ain steps:
1. Reading a CAD data base of a physical plant The program reads the CAD data base and recognises, depending on a pre-established naming and on the belonging layer or level, the blocks that must be treated, among which nodes, devices, central units, sections
2. User inputting
   The program receives from a user the following main selections for the process
   - Selecting the central plant
   - Selecting the plant to be treated
   - Selecting the circuit/s
   - Selecting the wiring structure (star, bus, loop)
   - Selecting the output on a table
   Moreover, a series of secondary settings are acquired, such as computation accuracy, field-separating character, automatic device numbering, dimensioning computations, etc.
3. Building a graph
   The program builds and stores, in an adequate structure, the connecting graph between the various blocks, verifying the connection of blocks (that become nodes), depending on the overlapping of the node block on the branch poly-line, using its thickness as tolerance. In this way, adjacent points between the various nodes are stored.
4. Spanning tree
   This passage is performed independently from the wiring structure, to verify that all nodes can be reached, even if it generates connection paths that are typical of the star wiring.
   By applying the Dijkstra algorithm (one of those available for finding the "minimum spanning tree") with a cycle based on the comparison of the route "weights" (that are equivalent to the cumulated distances), it is verified that all graph nodes are capable of being reached, and a subset is traced of the original graph that spans all nodes and minimised all distances from the central unit. A generic formulation of the Dijkstra algorithm is mentioned below:
   Suppose to have a graph with n vertexes designated by integer numbers {1,2,...,n}and that 1 is chosen as starting node. The weight on the arc joining nodes j and k is designated as *p(j,k)*. To every node, at the end of the analysis, two labels, *f(i),* must be associated, that point out the total route weight (the sum of weights on arcs used to get to the j-th node) and *J(i)*, that points out the node preceding i in the minimum path. Moreover, define two sets *S* and *T* respectively containing the nodes to which labels have already been assigned and nodes that still have to be scanned.

### 1. Initialisation

○ Set *S*={1}, *T*={2,3,...,n}, f(1)=0, J(1)=0.
○ Set f(i)=p(1,i), J(i)=1 for all nodes adjacent to 1.
○ set f(i)= ∞, for all other nodes.

### 2. Permanent label assignment

○ If f(i)= ∞ for every i in T **STOP**
○ Find j in T so that f(j)=min f(i) with i belonging to T
○ Set T=T\{j} and S=S□{j}
○ If T=Ø **STOP**

### 3. Temporary label assignment

○ For every i in T, adjacent to j and so that f (i)>f (j)+p(j,i) set:
   ■f(i)=f(j)+p(j,i)
   ■J(i)=j
○ Go to step 2
The nodes that cannot be reached for any reason are listed and notified to the user.
The algorithm potentially creates, for every device that can be reached, the shorter available connection path in the graph starting from the central unit.
If the selected wiring structure is the "star" one, the program proceeds with designing the located connection paths (see step 6). Alternatively, in case of backbone or loop wiring, the "TSP solving" is started

### 5. TSP solving

Such program section solves the known Travel Salesman Problem, TSP, to locate the shorter connection path mutually connecting all nodes and with the central unit, in the backbone or loop modes.

The problem of the theory of graphs being dealt with has been one of the most studied cases for years, taking into account the fact that, so far, there has not yet been an exact process available that provides the optimum solution.

Therefore, the problem is processed by using an "heuristic" algorithm of the "aimed attempts" type. Among the many algorithms available in literature, it has been chosen to use the one called "simulated annealing" because, at first sight, it has been deemed as the one that can be more easily adapted for this purpose. It cannot be excluded that it will be possible to use other, more efficient algorithms.

A generic formulation of the simulated annealing algorithm is mentioned below:
1. An arbitrary starting temperature is chosen:
   a. The problem is analysed in order to find the possible solutions (from 50 to 100 solutions);
   b. For every possible solution, its cost is computed;
   c. Take Δ*Emax;*
   d. Now take a starting temperature that is greater than the energy variation (*Tstarting* > Δ*Emax*) but of the same order of magnitude;
2. The temperature is lowered till a value next to 0 is reached;
3. Next to the minimum value of T, a strong enough (energy) minimum will be found;
4. By repeating this cycle, the chance of finding the same solution tends to 0. If two equal solutions are found for two different tests of the same problem it means that, very likely, something does not work correctly.

The network temperature is defined so that:
1. If T is high: Ci is allowed to make high jumps and when a minimum is found, one can try and go on to discover whether it was only a local minimum;
2. If T is low: High jumps can still be made, but with a lower chance, then one proceeds with shorter steps;
3. Quick T reduction; this implies freezing some thermal fluctuations;
4. Very low T reduction; it can imply that the computation conclusion is not reached and therefore a global minimum is not found.

Before starting the algorithm, the graph is optimised, by storing all adjacent points between a node and another, computing their distances. Moreover, all "blind alleys" or "dried branches" are removed, namely all branches that do not take to any device.

In this way, the algorithm execution, per se quite demanding in terms of resources, is simplified. Moreover, the graph is prepared to be executed by establishing, in order to limit the algorithm complexity, parameters such as:
○ the number of iteration cycles (starting temperature of the SA algorithm)
○ the iteration step (temperature difference between a cycle and another)
○ the weight coefficients of the probability evaluation for the route acceptance
○ the number of maximum passages from a certain node
○ etc.

The algorithm gets to find a path that does not guarantee to be the absolute minimum one, but, with a good calibration of parameters and in the necessary time, provides an optimum approximation thereof.

With a good certainty, it can be stated that the circuitry path has been optimised for the plant that will then be installed therein. Savings on materials and circuit installation thereby follow, and minimising the devices that supply the circuit.

After having ended the algorithm, the minimum connection path is defined and the cable design is performed.

### 6. Designing and computing cables and sections

In this program section, all connection paths are run and, for every connection branch (that corresponds to the cable, or cable section, or circuit section of the treated type) the design is performed on the CAD data base, by moving in all nodes that are part of the connection path. In this way, after having traced the actual circuit length, the circuit dimensioning computations can be performed:
o electric case: section and type of electric cable conductors
○ venting case: dimension of channels, load losses, etc.

Moreover, all circuits are located that pass inside the sections that have to be traced (defined on the CAD data base); then, by knowing the dimension (diameter or section) of such circuit, their filling can be deduced, allowing the correct dimensioning of these latter ones.

Such possibility allows an accurate dimensioning, based on a punctual and realistic simulation, of the plants, which is instead generally performed with wide approximations and high risks of under-dimensioning or waste of resources.

### 7. Outputting on a table

The program results are written on a table as a listing, by listing all physical circuit segments that can be located and including the computed physical characteristics together with the crossed sections.

Such tabular format allows an easy post-processing of included information (statistical filling reports, connections to cables or channels data base, etc.)

Now, the program has ended its execution on the examined circuit and can be automatically repeated on all selected circuits or plants.

The invention further deals with a computer program product comprising computer program instructions that, when they are run on a computer, are adapted to perform a process as described above.

For completeness, the Visual Basic code of the "main" function is included:

```
   Private Sub ARteMain()

        'on error GoTo erroreGenerale
        If ARteInput.DelAllCables Then
        dialog vbCr & "Deletion of all previous cables..."
        For Each tempEntity In ThisDrawing.ModelSpace
        If (Split(tempEntity.Layer, "_") (0) "ARteCables") Then
        tempEntity.delete
        End If
        Next
        End If


      ARteInput.StartName = UCase(Trim(ARteInput.StartName))
        Call findStart

        If ARteInput.CablesTableGen.Value = True Then
        excelInit
        End If


        For k = 0 To ARteInput.Plants.ListCount - 1
        If ARteInput.Plants.Selected(k) Then
        Processing.ProcessProgress.Value = 0
        plantName = Trim(UCase(ARteInput.Plants.List(k)))
        dialog vbCr & "Plant wiring " & plantName & "..."
        If ARteInput.CircuitSelection Then
        ARteInput.Circuits.Clear
        ARteInput.Circuits.AddItem (ARteInput.CircuitName)
        ARteInput.Circuits.Selected(0) = True
        SelectedCircuitsN = 1
        ElseIf ARteInput.circuitiVari Then
        ARteInput.Circuits.Clear
        dialog vbCr&. "Circuits check..."
        Call checkCircuits(plantName)
        SelectedCircuitsN = 0
        For i = 0 To ARteInput.Circuits.ListCount - 1
        ARteInput.Circuits.Selected(i) = True
        SelectedCircuitsN = SelectedCircuitsN + 1
        Next
        End If
        If SelectedCircuitsN >= 0 Then
        dialog vbCr & "Data fields attribute update..."
        ThisDrawing.SendCommand ("_ai_selall" + vbCr)
        ThisDrawing.SendCommand ("_updatefield" + vbCr)
        ReDim Preserve NodesExplored(SelectedCircuitsN - 1, 0)
        ReDim Preserve nodesExploredN(SelectedCircuitsN - 1)
        j = 0
        For i = 0 To ARteInput.Circuits.ListCount - 1
        If ARteInput.Circuits.Selected(i) Then
        ARteInput.CircuitName.Text =
   Trim(UCase(ARteInput.Circuits.List(i)))
        dialog vbCr & vbTab & "Circuit wiring " &
   ARteInput.CircuitName.Text & "..."
        Call ARteStar(j)
        j = j + 1
        End If
        Next
        j = 0
        If ARteInput.Star Then
        For i = 0 To ARteInput.Circuits.ListCount - 1
        If ARteInput.Circuits.Selected(i) Then
        If nodesExploredN(j) > 0 Then
        ARteInput.CircuitName.Text =
   Trim(UCase(ARteInput.Circuits.List(i)))
        dialog vbCr & vbTab & "Cable design on circuit " &
   ARteInput.CircuitName.Text &"..."
        Call DisegnoStar(j)
        End If
        j = j + 1
        End If
        Next
        Else
        If ARteInput.CablesTableGen.Value Then Call excelSave
        diagstring = ""
        j = 0
        For i = 0 To ARteInput.Circuits.ListCount - 1
        If ARteInput.Circuits.Selected(i) Then
        If nodesExploredN(j) > 0 Then
        ARteInput.CircuitName.Text =
   Trim(UCase(ARteInput.Circuits.List(i)))
        dialog vbCr & vbTab & "Minimum path computation on circuit " &
   ARteInput.CircuitName.Text & "..."
        Call ARteSA(j, diagString)
        If ARteInput.CablesTableGen.Value Then Call excelSave
        End If
        j = j + 1
        End If
        Next
        If diagstring <> "" Then
        dialog vbCr & vbTab & "The following nodes have an invalid
   detachment attribute: " & diagstring
        End If
        End If
        Else: dialog vbCr & vbTab & "There are no nodes with valid
   circuit identification (plant "' & plantName & "')"
        End If
        For i = 0 To nodesN - 1
        If Not nodes(i) Is Nothing Then nodes(i).resetNode
        Next
        Erase NodesExplored
        Erase nodesExploredN
        End If
       Next k
        If ARteInput.CablesTableGen.Value = True Then
       Call excelClose
       ARteInput.NewTabFile = False
       ARteInput.ExistingTabFile = True
       End If

        Processing.Caption = "ARte - Process completed"
       dialog vbCr & "Process completed."

   erroreGenerale:
       If Err.Number <> 0 Then
       Call MsgBox ("Process not completed:" & vbCr & Err.Description,
  vbCritical)
       abortARte = False
       dialog vbCr & "Process not completed:" & vbCr &
  Err.Description
       Processing.Caption = "Process not completed"
       Err.Clear
       If Not ExcelWorkbook Is Nothing Then
       If Not ExcelWasRunning Then ExcelWorkbook.Close (False)
       End If
       End If
       Start.delete
        Set Start = Nothing
        Set tempEntity = Nothing
        Set tempBlock = Nothing

        Set ExcelSheet = Nothing
        Set ExcelWorkbook = Nothing
        Erase NodesExplored
        Erase nodesExploredN
        For i = 0 To nodesN - 1
        If Not nodes(i) Is Nothing Then nodes(i).resetNode
        Next
   End Sub
```

## Claims

1. Process for automatically wiring and routing for networks of plants, comprising the steps of:
a. reading a CAD data base of a physical plant, comprising the sub-steps of reading the CAD data base and recognising, depending on a pre-established naming and on the belonging layer or level, the blocks that must be treated, among which nodes, devices, central units, sections;
b. user inputting, comprising the sub-steps of selecting the central unit; selecting the plant to be treated; selecting the circuit/s; selecting the wiring structure (star, bus, loop); and selecting the output on a table;
c. building a graph, performed depending on the read CAD data base and on the received user input, said step of building a graph comprising the sub-steps of building and storing a connection graph between the various blocks, verifying the connection of blocks, that become nodes, depending on an overlapping of node blocks on a branch poly-line, using its thickness as tolerance, thereby storing the adjacent points between the various nodes;
d. spanning tree, said spanning tree step being performed independently from the wiring structure, to verify that all nodes can be reached;
e. TSP solving, to locate the shorter connection path mutually connecting all nodes and with the central unit;
f. designing and computing cables and sections, comprising the sub-steps of moving along all connection paths, for every connection branch, corresponding to the cable, or cable section, or circuit section of the treated type, of performing the design on the CAD data base by moving along all nodes that are part of the connection path; and
g. outputting process results on a table, **characterised in that** step d) of spanning tree is performed independently from the wiring structure, to verify that all nodes can be reached, even if it generates connection paths that are typical of the star wiring, said step d) comprising the sub-steps of applying an algorithm adapted to find a "minimum spanning tree", with a cycle based on a comparison of route "weights", that are equivalent to cumulated distances, being thereby verified that all graph node can be reached, and being then able to trace a subset of the original graph covering all nodes and minimising all distances from the central unit, the nodes that cannot be reached for any reason being listed and reported to a user, step d) of spanning tree potentially creating, for every device that can be reached, the shorter connection path available in the graph starting from the central unit.

2. Process according to claim 1, wherein step b) of user inputting further comprises the steps of acquiring a series of secondary settings, such as computation accuracy, field-separating character, automatic devices numbering and dimensioning computations.

3. Process according to claim 1, wherein step d) further comprises, if the selected wiring structure is the "star" one, the sub-step of designing the located connection paths, or alternatively, in cases of backbone or loop wiring, the sub-step of starting step e) of TSP solving.

4. Process according to claim 1, wherein step e) of TSP solving is adapted to solve the Travel Salesman Problem, TSP, to locate the shorter connection path mutually connecting all nodes and with the central unit, in the backbone or loop mode, step e) using an "heuristic" algorithm of the "aimed attempts" type, preferably the algorithm called "simulated annealing", step e) further comprising, before starting the algorithm, the sub-step of optimising the graph, by storing all adjacent points between a node and another, computing their distances, and further removing all "blind alleys" or "dried branches", namely branches that do not go to any device.

5. Process according to claim 4, wherein the graph is prepared to be executed by establishing, in order to limit the algorithm complexity, parameters such as:
o the number of iteration cycles (starting temperature of the SA algorithm)
o the iteration step (temperature difference between a cycle and another)
○ the weight coefficients of the probability evaluation for the route acceptance
○ the number of maximum passages from a certain node.

6. Process according to claim 1, wherein step f) of designing and computing cables and sections comprises the sub-step, after having traced the actual circuit length, of computing the circuit dimensioning as follows:
○ electric case: section and type of electric cable conductors
○ venting case: dimension of channels, load losses, etc.

7. Process according to claim 6, wherein step f) further comprises the sub-steps of locating all circuit passing inside the sections that have to be traced, defined on the CAD data base, and, knowing the dimension, such as diameter or section, of such circuits, deducting the filling, allowing the correct dimensioning of these latter ones.

8. Process according to claim 1, wherein step g) of outputting on a table comprises the sub-steps of writing the process results on a table as listing, by listing all physical circuit segments that can be located and including the computed physical characteristics together with the crossed sections.

9. Computer program product comprising computer program instructions that, when run on a computer, are adapted to perform a process according to any one of the previous claims.

## Patentansprüche

1. Verkabelungsverfahren und automatische Leitweglenkung für Anlagennetze, das folgende Phasen einschließt:
a. Lesen einer CAD-Datenbasis einer physischen Anlage, was die Unterphasen des Lesens der CAD-Datenbasis und die Erkennung der Blöcke, die behandelt werden müssen, u. a. Knoten, Vorrichtungen, Zentralen, Abschnitte, aufgrund einer vorbestimmten Nomenklatur und einer Schicht oder eines Zugehörigkeitsniveaus einschließt;
b. Benutzer-Input, das die Unterphasen der Auswahl der Zentrale einschließt; Auswahl der zu behandelnden Anlage; Auswahl des/der Kreislaufs/Kreisläufe; Auswahl der Verkabelungsstruktur (Stern, Bus, Ring); und Auswahl des Outputs in einer Tabelle;
c. Konstruktion einer Graphik, die gemäß der gelesenen CAD-Datenbank und des empfangenen Benutzer-Inputs ausgeführt wird, die genannte Konstruktionsphase eines Graphens schließt die Unterphasen der Konstruktion und Speicherung eines Graphens für die Verbindung zwischen den verschiedenen Blöcken ein, prüft die Verbindung der Blöcke, aus denen Knoten werden, aufgrund der Überlagerung des Knotenblocks auf einer Polylinie des Zweiges, verwendet ihre Stärke als Toleranz, und speichert auf diese Weise die Nähe der verschiedenen Knoten zueinander;
d. Spanning Tree, die genannte Spanning Tree Phase wird unabhängig von der Verkabelungsstruktur ausgeführt, um die Erreichbarkeit aller Knoten zu prüfen;
e. TSP Solving, um den kürzeren Verbindungsweg zu finden, der alle Knoten untereinander und mit der Zentrale verbindet;
f. Zeichnung und Berechnung der Kabel und Abschnitte, die die Unterphasen des Durchlaufs aller Verbindungswege für jeden Verbindungszweig einschließt, der dem Kabel oder Kabelabschnitt oder Kreisabschnitt des behandelten Typs für die Ausführung der Zeichnung aufgrund der CAD-Daten entspricht, indem alle Knoten durchlaufen werden, die Teil des Verbindungsweges sind; und
g. Output der Ergebnisse des Verfahrens in einer Tabelle,
und **dadurch gekennzeichnet ist, dass** die Phase d) Spanning Tree unabhängig von der Verkabelungsstruktur ausgeführt wird, um die Erreichbarkeit aller Knoten zu prüfen, auch wenn sie Verbindungswege erzeugt, die typisch für eine Sternverkabelung sind, die genannte Phase d) schließt die Unterphasen der Anwendung eines Algorithmus ein, der dazu dient, den "minimalen Spannbaum" oder "Minimum Spanning Tree" mit einem Zyklus zu finden, der auf dem Vergleich der "Gewichte" der Wege basiert, die den gesammelten Entfernungen entsprechen, wodurch die Erreichbarkeit aller Knoten des Graphens geprüft wird, und eine Untergruppe des Ursprungsgraphens gezeichnet werden kann, der alle Knoten deckt und alle Entfernungen von der Zentrale minimiert, die Knoten, die aus beliebigen Gründen nicht erreichbar sind, werden angegeben und dem Benutzer mitgeteilt, die Phase d) Spanning Tree erzeugt potentiell für jede erreichbare Vorrichtung den kürzesten Verbindungsweg, der im Graphen von der Zentrale aus verfügbar ist

2. Verfahren gemäß Patentanspruch 1, in dem die Phase b) Benutzer-Input außerdem die Phase für die Erfassung von mehreren sekundären Einstellungen wie Berechnungspräzision, Feldtrennzeichen, automatische Nummerierung der Vorrichtungen und Berechnung der Abmessungen einschließt.

3. Verfahren gemäß Patentanspruch 1, in dem die Phase d), wenn die gewählte Struktur eine "Sternverkabelungsstruktur" ist, die Unterphase der Ausführung mit der Zeichnung der gefundenen Verbindungswege oder alternativ dazu, im Falle der Blackbone- oder Loopverkabelung, die Unterphase des Startens der Phase e) TSP Solving einschließt.

4. Verfahren gemäß Patentanspruch 1, in dem die Phase e) TSP Solving dazu dient, das Problem des TSP, "Travel Salesman Problem" oder "Problem des Handlungsreisenden" zu lösen, um den kürzesten Verbindungsweg zu finden, der in der Blackbone- oder Loopmodalität alle Knoten untereinander und mit der Zentrale verbindet, in der Phase e) wird ein "heuristischer" Algorithmus "mit gezielten Versuchen", vorzugsweise der als "simulated annealing" bezeichnete Algorithmus verwendet, die Phase e) schließt außerdem vor dem Start des Algorithmus die Unterphase der Optimierung des Graphens ein, die die Nähe zwischen den Knoten speichert, die Entfernungen berechnet und außerdem alle "Sackgassen" oder "trockenen Zweige", d. h. die Zweige, die zu keiner Vorrichtung führen, entfernt.

5. Verfahren gemäß Patentanspruch 4, in dem der Graph durch Festlegen folgender Parameter für die Ausführung vorbereitet wird, um die Kompliziertheit des Algorithmus zu begrenzen:
○ Anzahl der Iterationszyklen (Ausgangstemperatur des Algorithmus SA)
○ Iterationsschritt (Temperaturdifferenz zwischen den Zyklen)
○ Gewichtskoeffiziente der Wahrscheinlichkeitsrechnung für die Annahme des Weges
○ Anzahl der max. Durchläufe eines bestimmten Knotens.

6. Verfahren gemäß Patentanspruch 1, in dem die Phase f) Zeichnung und Berechnung der Kabel und Abschnitte nach der Zeichnung der effektiven Länge des Kreises, die Berechnung der Abmessung des Kreises wie folgt einschließt:
○ Fall der Elektrik: Abschnitt und Typologie der Stromkabelleiter
○ Fall der Belüftung: Abmessung der Kanäle, Druckverluste usw.

7. Verfahren gemäß Patentanspruch 6, in dem die Phase f) außerdem die Unterphasen der Auffindung aller Kreise einschließt, die die Abschnitte durchlaufen, die gezeichnet werden sollen und auf CAD-Basis definiert werden, und wenn die Abmessung wie Durchmesser oder Abschnitt solcher Kreise bekannt sind, kann der Platzbedarf abgeleitet werden, sodass die korrekte Dimensionierung letzterer ermöglicht wird.

8. Verfahren gemäß Patentanspruch 1, in dem die Phase g) Output in der Tabelle die Unterphasen des Aufschreibens der Ergebnisse des Verfahrens in einer Tabelle in Listenform einschließt, wobei alle auffindbaren physischen Segmente des Kreises und alle physischen Eigenschaften aufgeführt werden, die zusammen mit den durchquerten Abschnitten berechnet werden.

9. Informatikprodukt, das Programmanweisungen für Computer enthält, die bei Ausführung auf einem Computer dazu dienen, ein Verfahren gemäß einem der vorhergehenden Patentansprüche zu realisieren.

## Revendications

1. Procédé de câblage et acheminement automatique pour réseaux d'installations, comprenant les phases de :
a. Lecture d'une base de données CAO d'une installation physique, comprenant les sous-phases de lecture de la base de données CAO et reconnaissance, en fonction d'une nomenclature préétablie et du rang ou niveau d'appartenance, des blocs qui doivent être traités parmi lesquels noeuds, dispositifs, centrales, sections;
b. input utilisateur, comprenant les sous-phases de sélection de la centrale; sélection de l'installation à gérer; sélection du (des) circuit(s) ; sélection de la structure du câblage (étoile, bus, anneau); et sélection de l'output sur tableau;
c. construction d'un graphe, exécutée selon la banque de données CAO lue et de l'input utilisateur reçu, ladite phase de construction d'un graphe en comprenant les sous-phases de construction et mémorisation d'un graphe de connexion entre les divers blocs, en vérifiant la connexion des blocs, qui deviennent noeuds, en fonction de la superposition du bloc de noeud sur une poly-ligne de la branche, en utilisant son épaisseur comme tolérance, en mémorisant ainsi les adjacences entre les divers noeuds .;
d. spanning tree, ladite phase de spanning tree étant exécutée indépendamment de la structure de câblage, pour vérifier la possibilité d'atteindre tous les noeuds;
e. TSP solving, pour identifier le parcours de raccordement mineur qui raccorde tous les noeuds entre eux et avec la centrale;
f. dessin et calcul câbles et sections, comprenant les sous-phases de glissement de tous les parcours de raccordement et, pour toute branche de raccordement, qui correspond au câble, ou morceau de câble, ou partie de circuit du type traité, d'effectuation du dessin sur la base de données CAO en parcourant tous les noeuds qui font partie du parcours de raccordement; et
g. output des résultats du procédé sur tableau,
**caractérisé par le fait que** la phase d) de spanning tree est exécutée indépendamment de la structure de câblage, pour vérifier l'accessibilité de tous les noeuds, même s'il génère des parcours de raccordement qui sont typiques du câblage en étoile, ladite phase d) en comprenant les sous-phases d'application d'un algorithme apte à trouver un «arbre minimum couvrant» ou «minimum spanning tree», avec un cycle basé sur la comparaison des «poids» des conduits, qui équivalent aux distances cumulées, étant donc vérifié l'accessibilité de tous les noeuds du graphe, et étant donc en mesure de tracer un sous-ensemble du graphe originaire qui couvre tous les noeuds et minimise toutes les distances de la centrale, les noeuds ne pouvant pas être atteints pour un motif quelconque en étant cités et notifiés à l'utilisateur, la phase d) de spanning tree en créant potentiellement, pour tout dispositif à atteindre, le parcours de raccordement mineur disponible dans le graphe à partir de la centrale

2. Procédé selon la revendication 1, où la phase b) d'input utilisateur comprend en outre la phase d'acquisition d'une série de configurations secondaires, comme précision de calcul, caractère de séparation des champs, numération automatique de dispositifs et calculs de dimensionnement.

3. Procédé selon la revendication 1, où la phase d) comprend en outre, si la structure de câblage sélectionnée est celle «en étoile», la sous-phase de procéder avec le dessin des parcours de raccordement identifiés, ou en alternative, dans le cas de câblage en dorsale ou loop, la sous-phase de démarrer la phase e) de TSP solving.

4. Procédé selon la revendication 1, où la phase e) de TSP solving est apte à résoudre le problème du TSP, «Travel Salesman Problem», ou «Problème du commis voyageur», pour identifier le parcours de raccordement mineur qui raccorde tous les noeuds entre eux et avec la centrale, dans la modalité dorsale ou loop, la phase e) en utilisant un algorithme «euristique» de type « avec tentatives ciblées», de préférence l'algorithme appelé «simulated annealing», la phase e) comprenant en outre, avant le démarrage de l'algorithme, la sous-phase d'optimisation du graphe, en mémorisant toutes les adjacences entre un noeud et l'autre, en calculant les distances, et en éliminant en outre tous les «impasses» ou «branches sèches» c'est-à-dire les branches qui ne mènent à aucun dispositif.

5. Procédé selon la revendication 4, où le graphe est préparé à l'exécution en établissant, pour limiter la complexité de l'algorithme, des paramètres comme :
○ le numéro de cycles d'itérations (température de départ de l'algorithme SA)
○ le step d'itération (différence de température entre deux cycles)
○ les coefficients de poids de l'évaluation de probabilité de l'acceptation du conduit
○ le nombre de passages maximums par un déterminé noeud.

6. Procédé selon la revendication 1, où la phase f) de dessin et calcul de câbles et sections comprend la sous-phase, après avoir tracé la longueur effective du circuit, de calcul de dimensionnement du circuit comme suit:
○ cas électrique : section et typologie des conducteurs du câble électrique
○ cas ventilation : dimension des canaux, pertes de chargement etc.

7. Procédé selon la revendication 6, où la phase f) comprend en outre les sous-phases d'identification de tous les circuits qui passent à l'intérieur des sections que l'on veut tracer, définies sur la base CAO, et, en connaissant la dimension, comme diamètre ou section, de ces circuits, de déduction du remplissage, permettant le dimensionnement correct de ces dernières.

8. Procédé selon la revendication 1, où la phase g) d'output sur tableau comprend les sous-phases d'écriture des résultats du procédé sur un tableau sous forme de listing, en répertoriant tous les segments physiques du circuit identifiables et en reportant les caractéristiques physiques calculées avec les sections traversées.

9. Produit informatique comprenant des instructions de programme d'ordinateur qui, quand elles sont exécutées sur un ordinateur, sont aptes à réaliser un procédé selon une quelconque des revendications précédentes.
